# EUROPEAN PATENT SPECIFICATION

(11) **EP 3 918 647 B1**
(45) Date of publication and mention of the grant of the patent: **08.03.2023**
(21) Application number: 20701905.0
(22) Date of filing: 07.01.2020
(51) Int. Cl.: H01L 51/42, H01L 51/48

(54) **PHOTOELECTRIC CONVERSION ELEMENT, DEVICE, AND POWER SUPPLY MODULE**
PHOTOELEKTRISCHES UMWANDLUNGSELEMENT, BAUTEIL, UND PHOTOVOLTAIKMODUL
ÉLÉMENT DE CONVERSION PHOTOÉLECTRIQUE, DISPOSITIF ET MODULE D'ALIMENTATION ÉLECTRIQUE

(30) Priority: 01.02.2019 JP 2019016728
(43) Date of publication of application: 08.12.2021
(73) Proprietor: Ricoh Company, Ltd., Tokyo 143-8555 (JP)
(72) Inventor: ARAI, Ryota, Tokyo 143-8555 (JP)
(74) Representative: Marks & Clerk LLP
(86) International application number: PCT/JP2020/000188
(87) International publication number: WO 2020/158304

(56) References cited:
- EP-A1- 3 343 656
- SULING SHEN ET AL: "Solution-Processable Organic Molecule Photovoltaic Materials with Bithienyl-benzodithiophene Central Unit and Indenedione End Groups", CHEMISTRY OF MATERIALS, vol. 25, no. 11, 21 May 2013 (2013-05-21), pages 2274-2281, XP55679252, ISSN: 0897-4756, DOI: 10.1021/cm400782q

## Description

### Technical Field

The present disclosure relates to a photoelectric conversion element, a device, and a power supply module.

### Background Art

In recent years, the power for driving electric circuits has become extremely low. Preparing for the coming IoT society, various electronic parts, such as sensors, have been able to be driven with very low electric power (order of microwatt). As utilization of sensors, applications of the sensors for energy harvesting elements have been expected as self-sufficient energy supplies capable of generating and consuming power in-situ. Among the energy harvesting elements, photoelectric conversion elements have been attracted attentions as elements capable of generating power anywhere as long as there is light. As energy harvesting elements, particularly demanded are photoelectric conversion elements capable of efficiently generating electric power with indoor light, such as light of fluorescent lamps, and light of LED lamps.

It has been known that short-circuit current density, which is properties of a photoelectric conversion element, is proportional to light intensity with the proviso that the same light source is used. This is the same when the photoelectric conversion element is a so-called organic thin-film solar cell. Organic thin-film solar cells known in the art have been developed based on that sunlight is a light source to be used. Among them, developments of P-type semiconductors have been particularly actively carried out.

A photoelectric conversion element using indoor light as a light source uses a fluorescent lamp or LED lamp as a light source not sunlight. Therefore it is desired that the photoelectric conversion element exhibits high photoelectric conversion properties against light emitted from a fluorescent lamp or LED lamp. Unlike sunlight, light emitted from a fluorescent lamp or LED lamp has a spectrum only in a visible light range. Therefore, a conjugated polymer-based P-type organic semiconductor used in a conventional photoelectric conversion element using sunlight has problems, such as (1) Voc is low because HOMO is shallow, and (2) a current value is low with light of a fluorescent lamp or LED lamp because matching of a spectrum is low. On the whole, there is a problem that photoelectric conversion efficiency is low against indoor light.

Accordingly, developments of materials suitable for spectra of fluorescent lamps or LED lamps are desired, and low-molecular weight P-type organic materials have been actively developed (see, for example, PTL 1).

Organic semiconductors for photoelectric conversion elements are discussed in PTL2 and NPL2.

### Citation List

### Patent Literature

PTL 1: Japanese Unexamined Patent Application Publication No. 2017-139437
PTL2: European Patent Application EP 3 343 656 A1

### Non-Patent Literature

NPL 1: Chem. Sci., 2015, 6, 4860
NPL2: Chem. Mater., 2013, 25, 2274

### Summary of Invention

### Technical Problem

There has been a case where desired photoelectric conversion efficiency cannot obtained when a device is produced using a low-molecular weight P-type organic material known in the art.

The present disclosure has an object to provide a photoelectric conversion element realizing excellent photoelectric conversion efficiency and using a low-molecular weight P-type organic material.

### Solution to Problem

According to one aspect of the present disclosure, a photoelectric conversion element is as described in (1) below.
(1) A photoelectric conversion element including:
   a substrate;
   a first electrode;
   an electron-transporting layer;
   a photoelectric conversion layer;
   a hole-transporting layer; and
   a second electrode, where the first electrode, the electron-transporting layer, the photoelectric conversion layer, the hole-transporting layer, and the second electrode are disposed on or above the substrate,
   wherein the photoelectric conversion layer includes an organic material represented by General Formula (1) below, and a N-type semiconductor material, 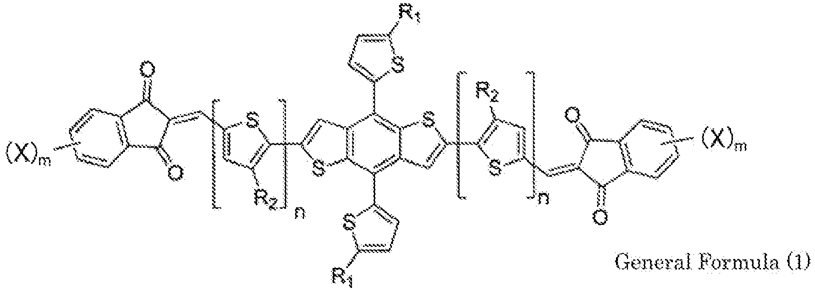 where, in General Formula (1), R₁ and R₂ are each independently an alkyl group having 6 or more but 22 or less carbon atoms, n is each independently an integer of from 1 through 3, X is each independently a halogen atom, and m is each independently 1 or 2.

### Advantageous Effects of Invention

The photoelectric conversion element of the present disclosure exhibits excellent photoelectric conversion efficiency with using a low-molecular weight P-type organic material.

### Brief Description of Drawings

[fig.1]FIG. 1 is a schematic cross-sectional view illustrating a structure of one embodiment of the photoelectric conversion element of the present disclosure.
[fig.2]FIG. 2 is a schematic cross-sectional view illustrating a structure of another embodiment of the photoelectric conversion element of the present disclosure.
[fig.3]FIG. 3 is a schematic view illustrating an example of a basic structure of a device in which the photoelectric conversion element is mounted.
[fig.4]FIG. 4 is a schematic view illustrating a structure including a power supply IC of the device in which the photoelectric conversion element is mounted.
[fig.5]FIG. 5 is a schematic view illustrating another structure where a power storage device is mounted between a power supply IC of a device in which the photoelectric conversion element is mounted and a device circuit.
[fig.6]FIG. 6 is a schematic view illustrating a structure of a device coupled with a commercial power supply for a conventional device, and operated by supplying direct current to a circuit of the device.
[fig.7]FIG. 7 is a schematic view illustrating a structure of a conventional device where a battery cell is mounted therein, and the device is driven by electricity of the battery cell.
[fig.8]FIG. 8 is a schematic view illustrating an example of the power supply module where the photoelectric conversion element and a power supply IC for the photoelectric conversion element are connected.
[fig.9]FIG. 9 is a schematic view illustrating an example of a power supply module where the photoelectric conversion element, a power supply IC for the photoelectric conversion element, and a power storage device are connected.

### Description of Embodiments

An organic material and a photoelectric conversion element according to the present disclosure will be described below with reference to drawings.

Note that, the present disclosure is not limited to embodiments described below, and other embodiments, additions to the embodiments, and eliminations from the embodiments are also included in a scope of the present disclosure, as long as the above-mentioned changes are made within a scope at which a person skilled in the art can easily arrive, and any of the embodiments can exhibit functions and effects of the present disclosure.

In the present disclosure, the term "photoelectric conversion element" means an element which converts optical energy into electric energy, or an element which converts electric energy into optical energy. Specific examples of the photoelectric conversion element include solar cells and photo diodes.

The present disclosure relates to the photoelectric conversion element of (1) below, but also includes (2) to (7) below as embodiments thereof. Therefore, the embodiments of (2) to (7) will be also described together with the embodiment of (1).
(1) A photoelectric conversion element including:
   a substrate;
   a first electrode;
   an electron-transporting layer;
   a photoelectric conversion layer;
   a hole-transporting layer; and
   a second electrode, where the first electrode, the electron-transporting layer, the photoelectric conversion layer, the hole-transporting layer, and the second electrode are disposed on or above the substrate,
   wherein the photoelectric conversion layer includes an organic material represented by General Formula (1) below, and a N-type semiconductor material, 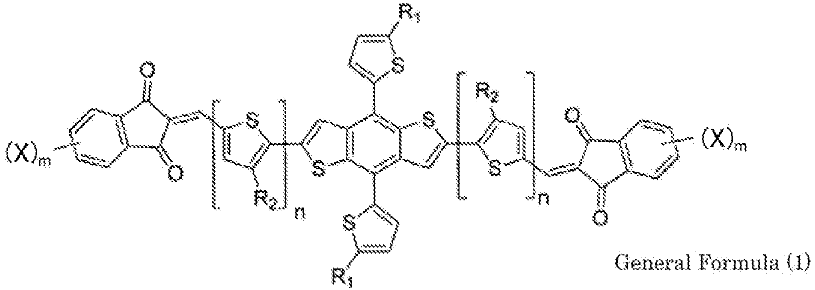
   where, in General Formula (1), R₁ and R₂ are each independently an alkyl group having 6 or more but 22 or less carbon atoms, n is each independently an integer of from 1 through 3, X is each independently a halogen atom, and m is each independently 1 or 2.
(2) The photoelectric conversion element according to (1),
   wherein X of General Formula (1) is a bromine atom or an iodine atom.
(3) The photoelectric conversion element according to (1),
   wherein the compound represented by General Formula (1) is a compound represented by General Formula (2) below, 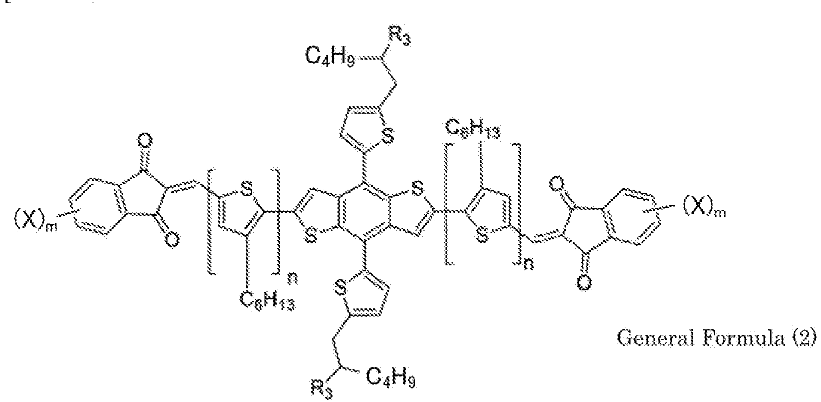 where, in General Formula (2), R₃ is each independently an alkyl group having 2 or more but 6 or less carbon atoms, n is each independently an integer of from 1 through 3, X is each independently a bromine atom or an iodine atom, and m is each independently 1 or 2.
(4) The photoelectric conversion element according to any one of (1) to (3),
   wherein the N-type semiconductor material is a fullerene derivative.
(5) The photoelectric conversion element according to any one of (1) to (4),
   wherein an average thickness of the photoelectric conversion layer is from 50 nm through 600 nm.
(6) A device including:
   the photoelectric conversion element according to any one of (1) to (5),
   wherein the device is driven by electricity generated by the photoelectric conversion element.
(7) A power supply module including:
   the photoelectric conversion element according to any one of (1) to (5).

### <<Organic material>>

The organic material for use in a photoelectric conversion layer of the photoelectric conversion element of the present disclosure is represented by General Formula (1) below.

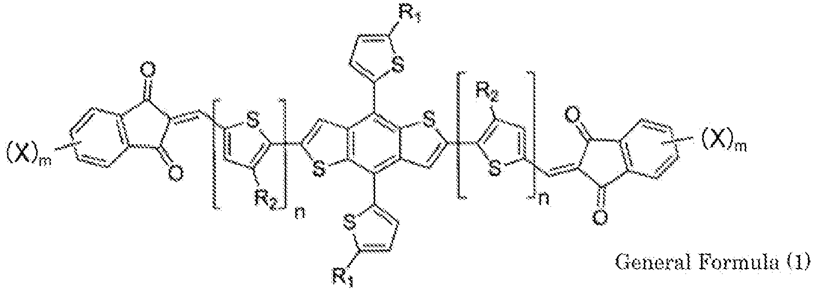

In General Formula (1), R₁ and R₂ are each independently an alkyl group having 6 or more but 22 or less carbon atoms, n is each independently an integer of from 1 through 3, X is each independently a halogen atom, and m is each independently 1 or 2.

R₁ and R₂ are each an alkyl group having 6 or more but 22 or less carbon atoms. Examples of the alkyl group include a n-hexyl group, a n-octyl group, a n-dodecyl group, a n-hexadecyl group, a 2-ethylhexyl group, a 2-butyloctyl group, and a 2-octyldodecyl group. R₁ is preferably a n-hexyl group. R₂ is preferably a 2-butyloctyl group.
n is an integer of from 1 through 3, and is preferably 1 or 2.
X is a halogen atom, and is preferably a bromine atom or an iodine atom. m is 1 or 2, and is preferably 1.

Regarding substitution positions, moreover, it is difficult to control 2 and 3 substitution positions in General Formula (1') below due to restriction of synthesis. Therefore, the organic material is a mixture of a 2-position substituted compound and a 3-position substituted compound. A substituent at a position where X is not substituted is inevitably a hydrogen atom.

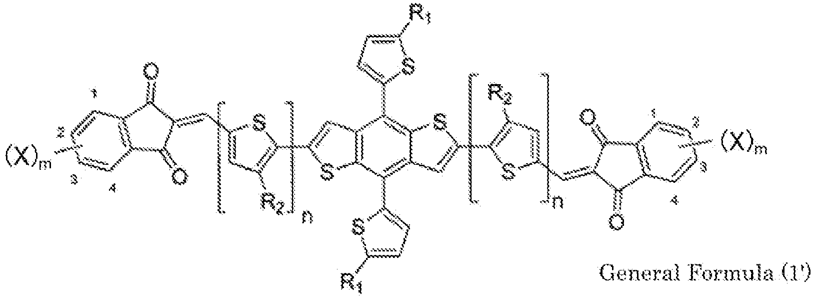

Specific examples of the organic material represented by General Formula (1) include Exemplified Compounds 1 to 48 having structures presented in Tables 1-1 to 1-3 below, but the organic material for use in the present disclosure is not limited to these examples.

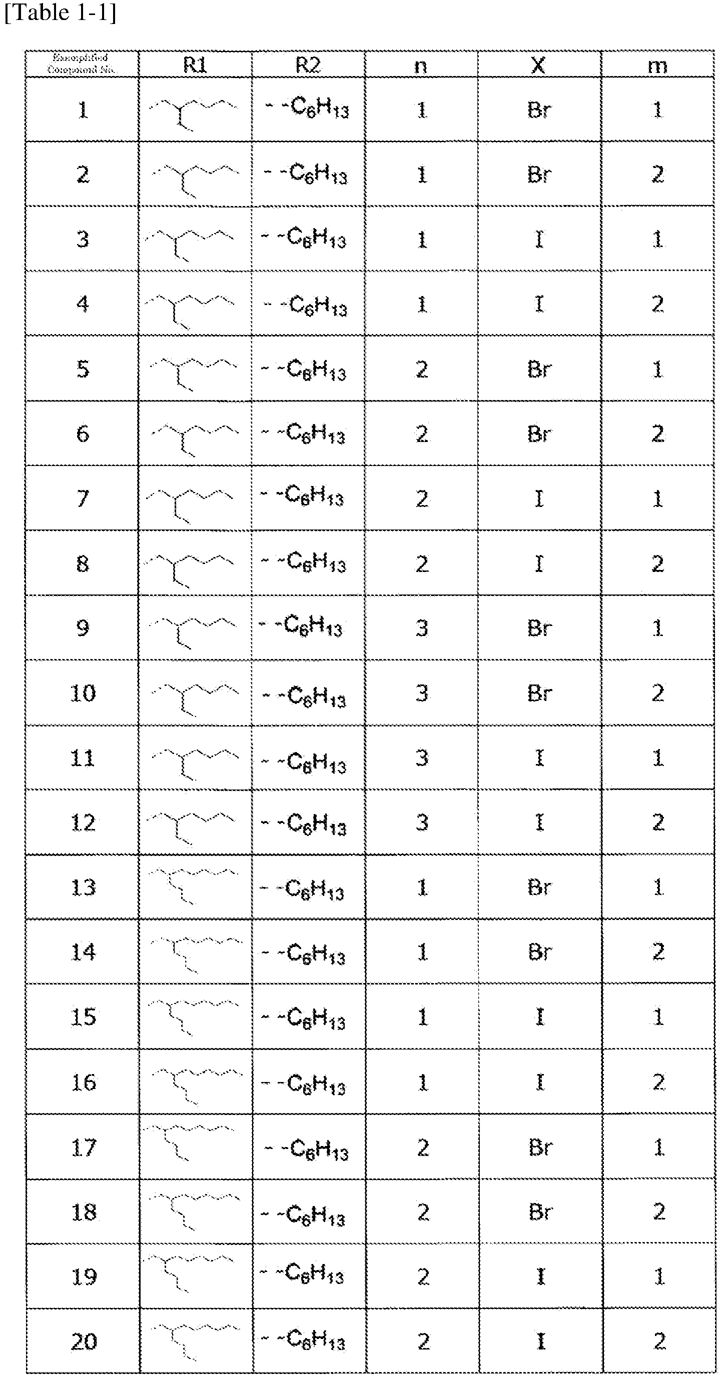

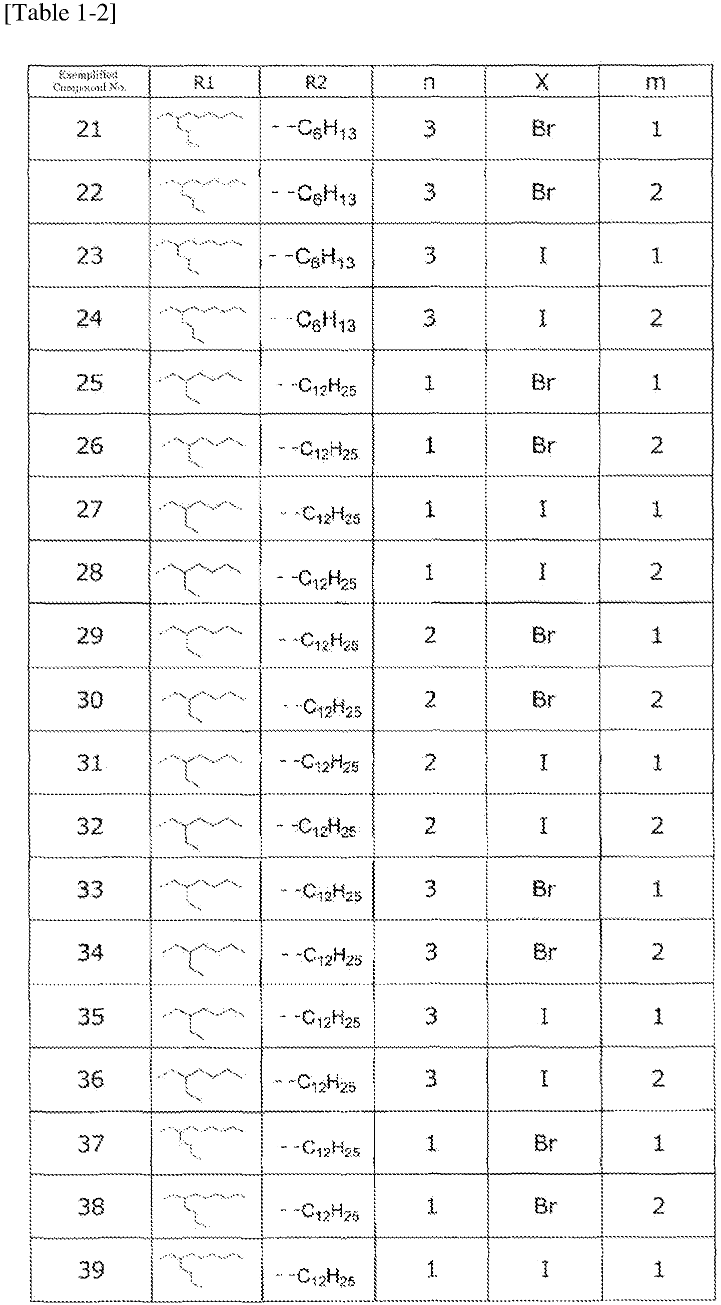

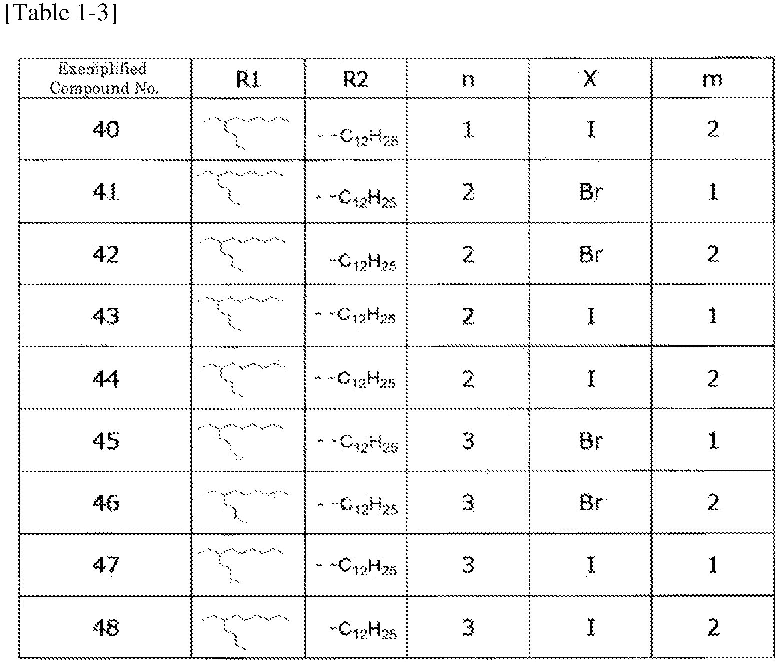

In Tables above, "C₆H₁₃" is a n-hexyl group, and "C₁₂H₂₅" is a n-dodecyl group. In Tables above, R₁ R₂, and n are both of two R_{1,} both of two R₂, and both of two n in General Formula (1), respectively.

Moreover, X is substituted at the 2-position or 3-position of General Formula (1').

### (N-type semiconductor material)

Examples of the N-type semiconductor material include a fullerene, and a fullerene derivative.

Among the above-listed examples, a fullerene derivative is preferable in view of charge separation and charge transport.

The fullerene derivative means a compound having a fullerene skeleton.

The fullerene derivative may be appropriately synthesized for use, or may be selected from commercial products. Examples of the commercial products thereof include phenyl C71 butyric acid methyl ester (PC71BM), PC61BM, and a fullerene indene 2-adduct.

In addition to the N-type organic material, an inorganic compound, such as zinc oxide and titanium oxide, may be used.

An amount of the N-type semiconductor material is preferably from 0.5% by mass through 10% by mass relative to a total amount of a photoelectric conversion layer solution.

The organic solvent is not particularly limited and may be appropriately selected depending on the intended purpose. Examples of the organic solvent include methanol, ethanol, butanol, toluene, xylene, o-chlorophenol, acetone, ethyl acetate, ethylene glycol, tetrahydrofuran, dichloromethane, chloroform, dichloroethane, chlorobenzene, dichlorobenzene, trichlorobenzene, chloronaphthalene, dimethylformamide, dimethylsulfoxide, N-methylpyrrolidone, and gamma-butyrolactone. The above-listed examples may be used alone or in combination. Among the above-listed examples, chlorobenzene, chloroform, and ortho-dichlorobenzene are preferable.

The above-mentioned other components are not particularly limited and may be appropriately selected depending on the intended purpose. Examples of the above-mentioned other components include various additives, such as 1,8-diiodooctane, 1,8-octanedithiol, and 1-chloronaphthalene.

### <Photoelectric conversion layer>

The photoelectric conversion layer includes at least a thin film of the organic material and the N-type semiconductor material, and may further include other components according to the necessity.

The average thickness of the photoelectric conversion layer is preferably 50 nm or greater but 600 nm or less, and more preferably 150 nm or greater but 500 nm or less. When the average thickness thereof is 50 nm or greater, a large quantity of light is absorbed by the photoelectric conversion layer and carriers are sufficiently generated. When the average thickness thereof is 600 nm or less, transport efficiency of carriers generated by light absorption in maintained without being reduced.

Since a conjugated system within a molecule of a low-molecular weight P-type semiconductor material known in the art is short, mobility of the low-molecular weight P-type semiconductor material is low compared to a conjugated polymer, and therefore a thick film of the low-molecular weight P-type semiconductor material may not be formed in a photoelectric conversion element. When the photoelectric conversion element is applied for a thin organic film solar battery cell, a problem, such as a leakage of a device, tends to occur because the thin organic film solar battery cell is an extremely thin film. Therefore, to make a thick film can produce a device having a high yield.

The organic material represented by General Formula (1) for use in the present disclosure is a low-molecular weight P-type organic material, but has high mobility, and high photoelectric conversion efficiency can be obtained even when a photoelectric conversion layer is formed as a thick film.

In the present disclosure, the organic material and the N-type semiconductor material may be sequentially formed to form flat junction interfaces. In order to increase an area of each junction interface, however, a bulk heterojunction where the above-mentioned materials are three-dimensionally mixed is preferably formed.

When materials having high solubility are used, the materials are dissolved in a solvent to form a solution where the organic material and the N-type semiconductor material are mixed in the state of molecules, and the solution is applied and then dried to remove the solvent, to thereby form a bulk heterojunction. Moreover, a heating treatment may be performed to optimize an aggregation state of each semiconductor.

When materials having poor solubility are used, the materials are dispersed in a solvent in which the organic material for use in the present disclosure is dissolved to prepare a solution, and the solution is applied to form a mixed layer. In this case, a heating treatment may be further performed to optimize an aggregation state of each semiconductor.

The organic material for use in the present disclosure has a deep HOMO level and excellent air stability, as well as that an improvement of open-circuit voltage owing to the material is expected. In addition, an organic semiconductor film having a regular coagulate state, such as crystallinity, and orientation, can be more effectively formed by introducing a soluble group, such as an alkyl group, into the above-mentioned rigid molecular skeleton, while maintaining solubility to typical organic solvents. In the above-mentioned state of high regularity, high charge transport can be expected. Particularly in a compound represented by General Formula (2') below among the compound represented by General Formula (1), an alkyl group substituted at the position of "*" is desirably a branched alkyl group. Since the alkyl chain thereof is a branched chain, solubility is significantly improved. As a result, a thin organic film can be made thick. Since the thin organic film is thick, a large quantity of light can be absorbed, leading to an improvement of power generation.

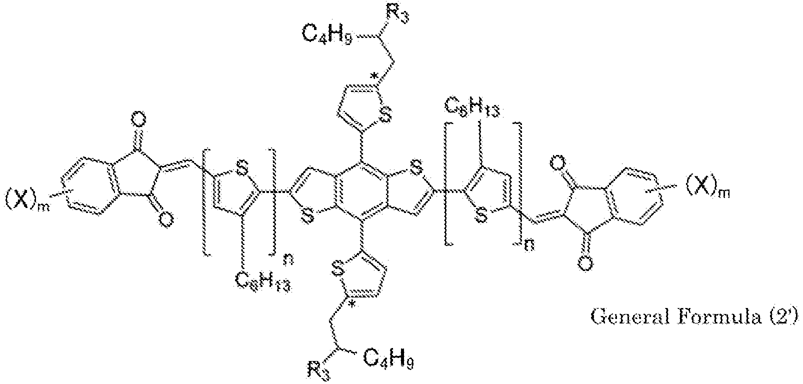

In the case where a photoelectric conversion layer is formed by mixing the organic material represented by General Formula (1) and the N-type semiconductor material, the organic material represented by General Formula (1) and the N-type semiconductor material are added to a solvent at a desired mass ratio, and the mixture is dissolved using a method, such as heating, stirring, and ultrasonic wave irradiation, to prepare a solution, and the solution is applied onto an electrode. In this case, a photoelectric conversion efficiency of a photovoltaic element by mixing two or more solvents.

Examples of a formation method of the photoelectric conversion layer include spin coating, blade coating, slit-die coating, screen-printing coating, bar-coater coating, mold coating, print transfer, dip coating, inkjet printing, spray coating, and vacuum vapor deposition. Among the above-listed examples, the formation method can be appropriately selected depending on properties of a thin organic material film to be produced, such as thickness controlling, and orientation controlling.

In the case where spin coating is performed, for example, a concentration of the organic material having a structure represented by General Formula (1) and the N-type semiconductor material (a mass of the organic material having a structure represented by General Formula (1) and the N-type semiconductor material relative to a volume is a solution including the organic material having a structure represented by General Formula (1), the N-type semiconductor material, and a solvent) is preferably from 10 mg/mL through 100 mg/mL. With the above-mentioned concentration, a uniform photoelectric conversion layer can be easily produced.

In order to remove the organic solvent, an annealing treatment may be performed on the produced photoelectric conversion layer under reduced pressure or an inert atmosphere (a nitrogen or argon atmosphere). A temperature of the annealing treatment is preferably from 40 degrees Celsius through 300 degrees Celsius, and more preferably from 50 degrees Celsius through 150 degrees Celsius. Since the annealing treatment is performed, moreover, stacked layers are penetrated into each other at interfaces, to thereby increase a contact effective area. As a result, a short-circuit current may be increased. Note that, the annealing treatment may be performed after forming electrodes.

### (Photoelectric conversion element)

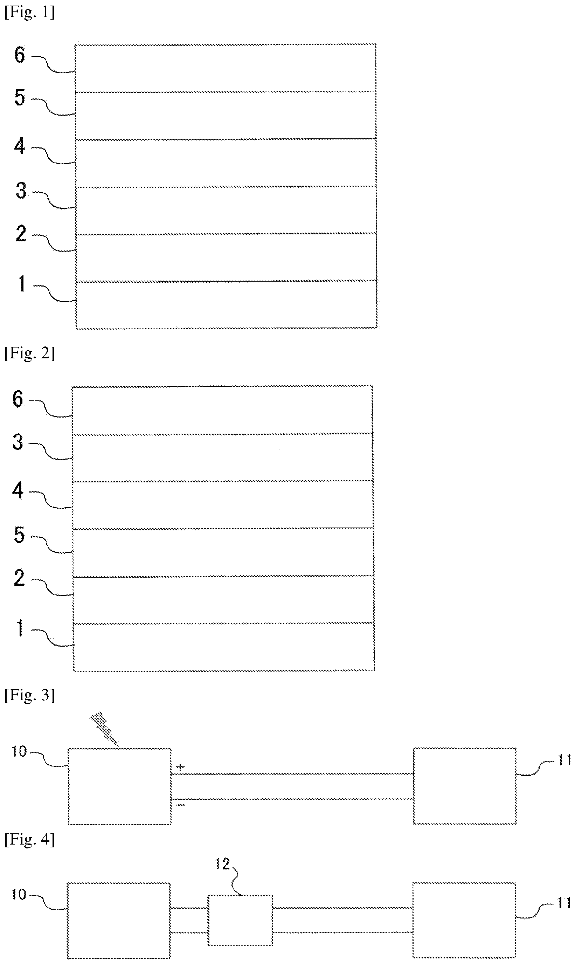

The photoelectric conversion element of the present disclosure is preferably a photoelectric conversion element where a first electrode, an electron-transporting layer, a photoelectric conversion layer, a hole-transporting layer, and a second electrode are sequentially disposed on or above a substrate, or a photoelectric conversion element where a first electrode, a hole-transporting layer, a photoelectric conversion layer, an electron-transporting layer, and a second electrode are sequentially disposed on or above a substrate. The photoelectric conversion layer includes a thin organic material film of the present disclosure. The photoelectric conversion element of the present disclosure will be described with reference to drawings. FIG. 1 is a view illustrating a laminate structure of the photoelectric conversion element, in which a first electrode 2, an electron-transporting layer 3, a photoelectric conversion layer 4, a hole-transporting layer 5, and a second electrode 6 are sequentially disposed on a substrate 1. FIG. 2 is a view illustrating a laminate structure of the photoelectric conversion element, in which a first electrode 2, a hole-transporting layer 5, a photoelectric conversion layer 4, an electron-transporting layer 3, and a second electrode 6 are sequentially disposed on a substrate 1.

### <Substrate>

The substrate for use in the present disclosure is not particularly limited and any of substrates known in the art can be used as the substrate. The substrate 1 is preferably a substrate formed of a transparent material. Examples of the substrate include glass, a transparent plastic plate, a transparent plastic film, and an inorganic transparent crystal.

### <Electrodes>

As the electrodes for use, one of electrodes is transparent to visible light, and the other electrode may be transparent or opaque.

The electrode transparent to visible light is not particularly limited and any of electrodes typically used in photoelectric conversion elements or liquid crystal panels may be used. Examples of the transparent electrode include conductive metal oxides, such as tin-doped indium oxide (referred to as "ITO" hereinafter), fluorine-doped tin oxide (referred to as "FTO" hereinafter), antimony-doped tin oxide (referred to as "ATO" hereinafter), and aluminium- or gallium-doped zinc oxide (referred respectively as "AZO," and "GZO" hereinafter).

An average thickness of the electrode transparent to visible light is preferably from 5 nm through 10 micrometers, and more preferably from 50 nm through 1 micrometer.

In order to maintain certain hardness, the electrode transparent to visible light is preferably disposed on a substrate formed of a material transparent to visible light. A product of the electrode and the substrate that are integrated can also be used. Examples of the integrated product include FTO coated glass, ITO coated glass, zinc oxide-aluminium coated glass, FTO coated transparent plastic films, and ITO coated transparent plastic films.

The electrode transparent to visible light may be an electrode containing a substrate (e.g., a glass substrate) on which a metal electrode having the structure through which light can pass (e.g., a mesh-patterned structure or a stripe-pattered structure) is disposed. Alternatively, the electrode transparent to visible light may be an electrode where carbon nanotube or graphene is laminated on the substrate in a manner that transparency is secured. The above-listed examples may be used alone, or in combination, or in the state of a laminate.

In order to reduce substrate resistance, moreover, a metal lead wire may be used. Examples of a material of the metal lead wire include metals, such as aluminium, copper, silver, gold, platinum, and nickel. The metal lead wire is disposed on the substrate, for example, by vapor deposition, sputtering, or crimping, followed by disposing ITO or FTO on the metal.

In the case where an opaque electrode is used for either a first electrode or a second electrode, examples of a material thereof include metals (e.g., platinum, gold, silver, copper, and Al) and graphite. In case of the opaque electrode, a thickness of the electrode is not particularly limited and the electrode may have a laminate structure of one or two or more materials.

### <Electron-transporting layer (first layer)>

A material for forming the electron-transporting layer may be appropriately selected depending on the intended purpose. For example, the electron-transporting layer is formed by applying an electron-accepting organic material [e.g., perylenetetracarboxylic anhydride, perylenetetracarboxylic diimide, oxazole derivatives, triazol derivatives, phenanthroline derivatives, phosphine oxide derivatives, fullerene compounds, CNT, and CN-PPV], or an inorganic material (e.g., zinc oxide, titanium oxide, lithium fluoride, and calcium metal) through a sol-gel method or sputtering. Among the above-listed examples, metal oxides, such as zinc oxide, titanium oxide, and tin oxide, are preferable. An average thickness of the electron-transporting layer is not particularly limited and may be appropriately selected depending on the intended purpose. The electron-transporting layer preferably covers the entire surface as thin as possible, and more preferably has an average thickness of from 10 nm through 100 nm. A film of basic carboxylic acid may be formed on an electron-transporting layer.

Specific examples of the basic carboxylic acid include 4-(N,N-dimethylamino)-benzoic acid, 4-(N,N-diethylamino)-benzoic acid, and 4-(N,N-dibenzylamino)-benzoic acid.

### <Hole-transporting layer>

The hole-transporting layer is disposed to improve a collection efficiency of holes. Specifically, the hole-transporting layer is formed by depositing a hole-transporting organic compound, such as a conductive polymer [e.g., PEDOT:PSS (polyethylene dioxythiophene:polystyrene sulfonic acid)] and an aromatic amine derivative, or an inorganic compound having hole-transporting properties, such as molybdenum oxide, vanadium oxide, and nickel oxide, through spin coating, a sol-gel method, or sputtering. In the present disclosure, molybdenum oxide is preferably disposed.

An average thickness of the hole-transporting layer is not particularly limited and may be appropriately selected depending on the intended purpose. The hole-transporting layer preferably covers the entire surface as thin as possible, and the average thickness of the hole-transporting layer is more preferably from 1 nm through 50 nm.

### <Other members>

The above-mentioned other members are not particularly limited and may be appropriately selected depending on the intended purpose. Examples of the members include a gas-barrier layer, a protective layer, and a buffer layer.

Examples of materials of the gas-barrier layer include inorganic materials, such as silicon nitrate, and silicon oxide.

The photoelectric conversion element of the present disclosure may have a series junction formed by stacking two or more photoelectric conversion layers (making as a tandem) via one or more intermediate electrodes.

Examples of the laminate structure include a laminate structure including a substrate 1/a first electrode 2/a hole-transporting layer 3/a first photoelectric conversion layer 4/an intermediate electrode/a second photoelectric conversion layer/an electron-transporting layer 5/a second electrode 6. Use of the laminate can improve open-circuit voltage.

In case of the above-described laminate structure, at least one of the photoelectric conversion layers includes a thin organic material film formed of the organic material represented by General Formula (1), and the other photoelectric conversion layer preferably includes another organic material having an absorption wavelength different from that of the organic material represented by General Formula (1) in order to prevent reduction of short-circuit current.

Examples of the above-mentioned another organic material include: polymer materials, such as polythiophene compounds, polyphenylene vinylene compounds, polyfluorene compounds, and polyphenylene compounds; and low-molecular-weight materials, such as various porphyrins, and phthalocyanine.

### <Use>

Recently, there is a need for, especially as an energy harvesting element, a photoelectric conversion element capable of efficiently generating electric power with weak light. Typical examples of weak light include LED light, and light of a fluorescent lamp. The above-mentioned light is typically used indoor, and is called indoor light. The illuminance of the indoor light is from about 20 Lux through about 1,000 Lux, and the indoor light is very weak light compared to direct sunlight (about 100,000 Lux).

The photoelectric conversion element of the present disclosure exhibits high conversion efficiency with weak light, such as the above-mentioned indoor light, and can be applied for a power supply by using in combination with a circuit board capable of controlling the generated electric current. Examples of a device utilizing the power supply include calculators, and watches. Other than the above-listed examples, a power supply containing the photoelectric conversion element of the present disclosure can be used in mobile phones, electric organizers, and electronic paper. Moreover, a power supply containing the photoelectric conversion element of the present disclosure can also be used as an auxiliary power for extending continuous usage of rechargeable or battery-driven electric appliances. Furthermore, the photoelectric conversion element of the present disclosure can be also applied as an image sensor.

A basic structure of the device mounted in the photoelectric conversion element is illustrated in FIG. 3. The photoelectric conversion element 10 illustrated in FIG. 3 generates electricity when the photoelectric conversion element receives light. The device circuit 11 can be operated by receiving the electricity.

Moreover, output of the photoelectric conversion element 10 generally changes depending on surrounding illuminance. In order to supply stable voltage to the side of the device circuit 11, a power supply IC 12 for the photoelectric conversion element is generally disposed between the photoelectric conversion element 10 and the device circuit 11. The structure described above is illustrated in FIG. 4.

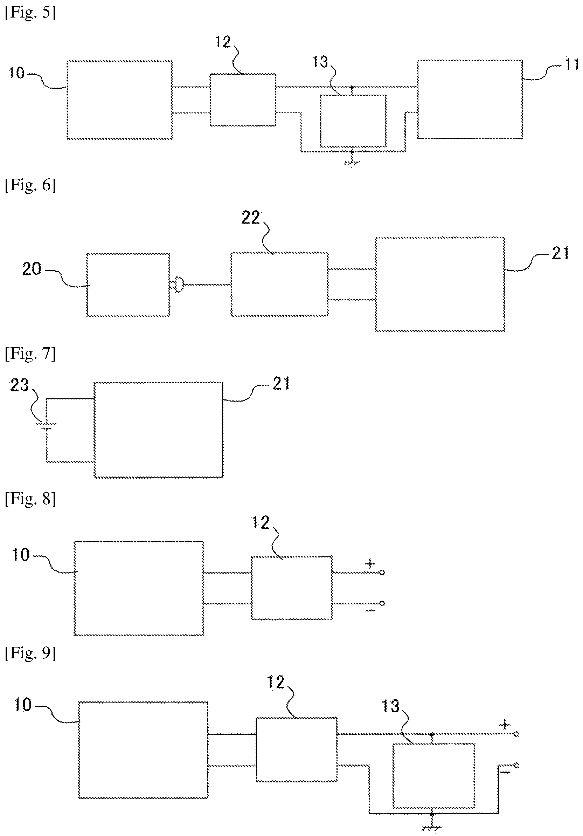

To prepare a case where light is not applied to the photoelectric conversion element 10 and electricity cannot be generated, a power storage device 13, such as a capacitor, is disposed between the power supply IC 12 and the device circuit 11, and therefore the power storage device 13 can be charged by excess electricity from the photoelectric conversion element 10. In the case where light is not applied to the photoelectric conversion element 10, the device can be operated by supplying the electricity stored in the power storage device 13 to the device circuit 11. The structure described above is illustrated in FIG. 5.

FIGs. 6 and 7 illustrate structures of devices known in the art.

The device known in the art is coupled with a commercial power supply 20 and is driven by converting alternating current into direct current power supply by a AC-DC converter 22 and supplying to the device circuit 21 (FIG. 6). Alternatively, a battery cell 23 is disposed inside the device, and the device circuit 21 is driven by electricity of the battery cell (FIG. 7).

However, the devices known in the art cannot be driven unless the devices are connected to a commercial power supply. A device driven by a battery cell needs replacement of the battery cell when the battery cell is run out.

The devices of FIGs. 3 to 5 can be driven in an environment where there is no commercial power supply, and can be continuously driven without replacing a battery cell.

FIGs. 8 and 9 illustrate schematic examples of the power supply module of the present disclosure.

The photoelectric conversion element 10 is coupled with a power supply IC 12 for the photoelectric conversion element (FIG. 8). In this manner, a direct current power supply module, which can supply electricity generated by receiving light in the photoelectric conversion element 10 with the power supply IC 12 at a constant voltage level, can be constructed. As a power storage device 13 is added to output of the power supply IC 12 (FIG. 9), moreover, the electricity generated by the photoelectric conversion element 10 is stored in the power storage device 13. In this manner, a power supply module capable of supplying electricity even in the state where no light is applied can be constructed.

The power supply modules of FIGs. 8 and 9 can be continuously used as a power supply module without replacing a battery cell, unlike a primary battery cell known in the art.

### <Synthesis Examples of exemplified compounds>

As a synthesis method of the organic material represented by General Formula (1) used in the photoelectric conversion layer of the photoelectric conversion element of the present disclosure, synthesis methods of Exemplified Compound 17 and Exemplified Compound 19 listed above will be described hereinafter.

### (Synthesis of Exemplified Compound 17)

### (1-1) Synthesis of 5-bromo-1H-indene-1,3(2H)-dione (Compound 1)

5-Bromo-1H-indene-1,3(2H)-dione (Compound 1) was synthesized using the following synthesis method.

### (Synthesis method)

To acetic anhydride (16.8 mL) and triethylamine (9.1 mL), 5-bromophthalicanhydride (6.81 g, 30.0 mmol) is added, and the resultant mixture is stirred. To the mixture, ethyl acetoacetate (4.2901 g, 33.0 mmol) is added, and the resultant mixture is stirred at room temperature overnight. Subsequently, ice (20 g) and concentrated HCl (48.4 mL) are added to the mixture.

The mixture is stirred for 20 minutes at 80 degrees Celsius in the atmosphere. After cooling the mixture to room temperature, extraction is performed with chloroform.

An organic layer is dried with anhydrous sodium sulfate. After performing filtration, the solvent is removed. The generated product is purified by silica gel chromatography (solvent: chloroform). The resultant is recrystallized with chloroform/hexane, and dried to thereby obtain pale yellow crystals of Compound 1 (yield = 5.06 g, 75%).

A reaction formula of the above-described reaction, and NMR spectrum values of obtained Compound 1 and a result of mass spectrometry thereof are presented below.

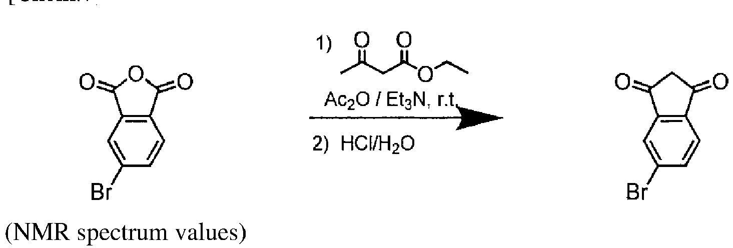

1H NMR (400 MHz, CDCl3) δ 8.12 (d, J = 1.8 Hz, 1H), 7.96 (dd, J = 8.0, 1.8 Hz, 1H), 7.85 (d, J = 8.0 Hz, 1H), 3.26 (s, 2H).

### (Result of mass spectrometry)

MS (MALDI-TOF) m/z: [M-H]-, 222.94; Found., 222.62.

### (1-2) Synthesis of

### 5',5‴-(4,8-bis(5-(2-butyloctyl)thiophen-2-yl)benzo[1,2-b:4,5-b']dithiophene-2,6-diyl)bi s(3,4'-dihexyl-[2,2'-bithiophene]-5-carbaldehyde) (Compound 2)

5',5‴-(4,8-Bis(5-(2-butyloctyl)thiophen-2-yl)benzo[1,2-b:4,5-b']dithiophene-2,6-diyl) bis(3,4'-dihexyl-[2,2'-bithiophene]-5-carbaldehyde) (Compound 2) is synthesized using the following synthesis method.

### (Synthesis method)

(4,8-Bis(5-(2-butyloctyl)thiophen-2-yl)benzo[1,2-b:4,5-b']dithiophene-2,6-diyl)bis(tr imethylstannane) (1.83 g, 1.80 mmol) and
5'-bromo-3,4'-dihexyl-[2,2'-bithiophene]-5-carbaldehyde (1.67 g, 3.78 mmol) are dissolved in anhydrous DMF (20 mL). To the resultant solution, Pd(PPh₃)₄ (83 mg, 0.072 mmol) is added. Bubbling is performed with nitrogen for 5 minutes, and then the resultant mixture is stirred at 80 degrees Celsius overnight. After cooling the resultant mixture to room temperature, methanol is added to precipitate, followed by performing filtration. The generated product is purified by silica gel chromatography (solvent: chloroform). The resultant is recrystallized with chloroform/methanol to thereby obtain a red solid of Compound 2 (yield = 2.20 g, 87%).

A reaction formula of the above-described reaction and NMR spectrum values of Compound 2 and a result of mass spectrometry thereof are presented below.

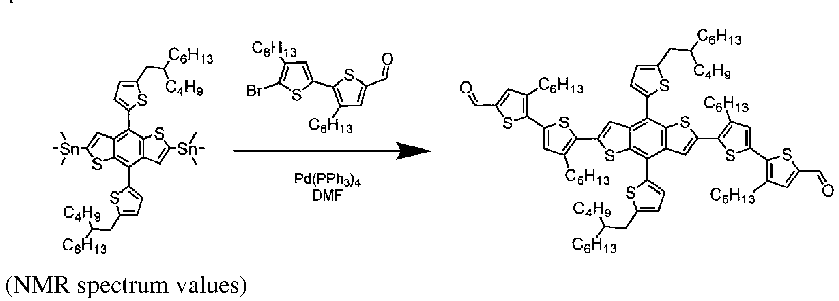

¹H NMR (400 MHz, CDCl₃) δ 9.83 (s, 2H), 7.70 (s, 2H), 7.59 (s, 2H), 7.35 (d, J = 3.5 Hz, 2H), 7.14 (s, 2H), 6.91 (d, J = 3.5 Hz, 2H), 2.88-2.80 (m, 12H), 1.72-1.65 (m, 10H), 1.38-1.28 (m, 56H), 0.92-0.84 (m, 24H).

### (Result of mass spectrometry)

MS (MALDI-TOF) m/z: [M+H]⁺, 1411.67; Found, 1411.14.

### (1-3) Synthesis of

### 2,2'-(((4,8-bis(5-(2-butyloctyl)thiophen-2-yl)benzo[1,2-b:4,5-b']dithiophene-2,6-diyl)bi s(3,4'-dihexyl-[2,2'-bithiophene]-5',5-diyl))bis(methaneylylidene))bis(5-bromo-1H-ind ene-1,3(2H)-dione) (Compound 3: Exemplified Compound 17)

Compound 3 (Exemplified Compound 17) is synthesized using the following synthesis method.

### (Synthesis method)

Compound 2 (706 mg, 0.500 mmol) and Compound 1 (236 mg, 1.05 mmol) are dissolved in chloroform (3 mL). To the resultant solution,
1,8-diazabicyclo[5.4.0]undec-7-ene (1 drop) is added. The mixture is stirred at 60 degrees Celsius overnight. After cooling the resultant mixture to room temperature, the generated product is directly purified by silica gel chromatography (solvent: chloroform). The resultant is recrystallized with chloroform/methanol to thereby obtain black crystals of Compound 3 (Exemplified Compound 17). Moreover, purification is performed by recycle GPC (solvent: chloroform) (yield = 490 mg, 54%).

A reaction formula of the above-described reaction and NMR spectrum values of Compound 3 (Exemplified Compound 17) and a result of mass spectrometry thereof are presented below.

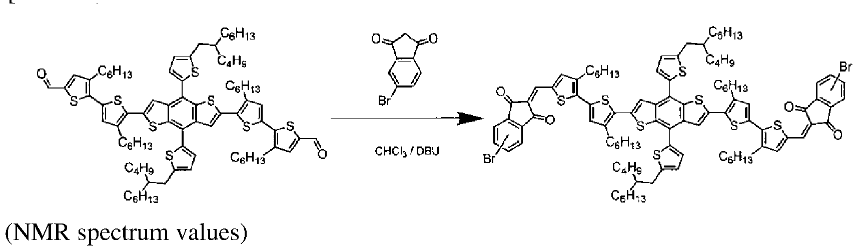

¹H NMR (500 MHz, CDCl₃) δ 8.04 (dd, J = 6.9, 1.6 Hz, 2H), 7.86-7.83 (m, 4H), 7.80-7.76 (m, 4H), 7.70 (d, J = 1.3 Hz, 2H), 7.39 (d, J= 3.5 Hz, 2H), 7.30 (s, 2H), 6.94 (d, J= 3.2 Hz, 2H), 2.91-2.82 (m, 12H), 1.78-1.67 (m, 10H), 1.44-1.26 (m, 56H), 0.93-0.85 (m, 24H). ¹³C NMR (126 MHz, CDCl₃) δ 189.43, 189.07, 188.80, 188.29, 146.22, 146.06, 145.97, 145.90, 145.84, 143.41, 142.09, 141.93, 141.26, 141.23, 140.56, 139.26, 139.05, 137.96, 137.78, 137.16, 136.91, 136.67, 136.56, 134.70, 134.67, 134.31, 134.13, 131.32, 130.28, 130.08, 128.10, 126.26, 126.14, 125.72, 124.45, 124.30, 123.68, 123.21, 122.21, 40.21, 34.93, 33.64, 33.21, 32.12, 31.85, 31.82, 30.71, 30.12, 29.92, 29.88, 29.56, 29.37, 29.08, 26.86, 23.26, 22.89, 22.87, 22.82, 14.39, 14.34, 14.32.

### (Result of mass spectrometry)

MS (MALDI-TOF) m/z: [M+H]⁺, 1823.54; Found, 1822.94. Anal. calcd (%) for C₁₀₂H ₁₂₀Br₂O₄S₈: C 67.08, H 6.62; found: C 67.13, H 6.62.

### (Synthesis of Exemplified Compound 19)

### (2-1) Synthesis of 4-iodophthalic acid (Compound 4)

4-Iodophthalic acid (Compound 4) is synthesized using the following synthesis method.

### (Synthesis method)

In pyridine (31.5 mL) and distilled water (66 mL), 4-iodo-1,2-dimethylbenzene (3.48 g, 15.0 mmol) is dissolved. To the resultant solution, KMnO₄ (23.7 g, 150 mmol) is added. The mixture is subjected reflux for 24 hours. The mixture is filtered with the same temperature, and the obtained residues are washed with a KOH aqueous solution (1 M, 100 mL). Subsequently, concentrated hydrochloric acid is added to the resultant till pH thereof becomes 1, and an organic layer is extracted with ethyl acetate. The organic layer is dried with anhydrous sodium sulfate, followed by performing filtration. The solvent is removed from the resultant, to thereby obtain Compound 4 that is a white solid (yield = 3.58 g, 82%).

A reaction formula of the above-described reaction, and NMR spectrum values of obtained Compound 4 and a result of mass spectrometry thereof are presented below.

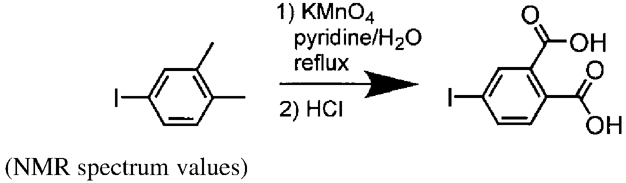

¹H NMR (400 MHz, CDCl₃) δ 8.22 (d, J = 1.8 Hz, 1H), 7.99 (dd, J = 8.3, 1.8 Hz, 1H), 7.64 (d, J = 8.0 Hz, 1H).

### (Result of mass spectrometry)

MS (MALDI-TOF) m/z: [M-H], 290.92; Found, 290.81.

### (2-2) Synthesis of 5-iodoisobenzofuran-1,3-dione (Compound 5)

Compound 4 (3.42 g, 11.7 mmol) is dissolved in acetic anhydride (50 mL). The resultant solution is stirred at 100 degrees Celsius overnight. After removing the solvent, Compound 5 that is a yellow solid is obtained (yield = 2.94 g, 92%).

A reaction formula of the above-described reaction, and NMR spectrum values of obtained Compound 5 and a result of mass spectrometry thereof are presented below.

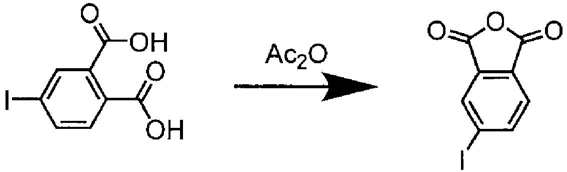

(NMR spectrum values)

¹H NMR (400 MHz, CDCl₃) δ 8.38 (d, J = 1.0 Hz, 1H), 8.26 (dd, J = 8.0, 1.5 Hz, 1H), 7.73 (d, J = 8.3 Hz, 1H).

### (Result of mass spectrometry)

MS (MALDI-TOF) m/z: [M-H], 272.91; Found, 272.50.

### (2-3) Synthesis of 5-iodo-1H-indene-1,3(2H)-dione (Compound 6)

In the same manner as described in the synthesis of Compound 1, synthesis and purification are performed using Compound 5 (1.51 g, 5.50 mmol) and ethyl acetoacetate (0.787 g, 6.05 mmol), to thereby obtain pale yellow crystals of Compound 6 (yield = 1.06 g, 71%).

A reaction formula of the above-described reaction, and NMR spectrum values of obtained Compound 6 and a result of mass spectrometry thereof are presented below.

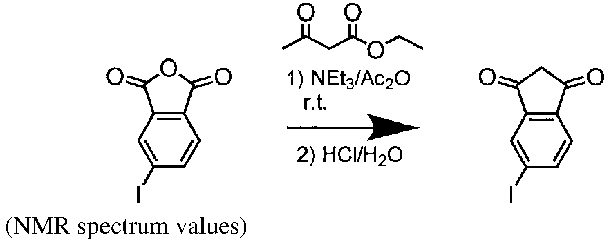

¹H NMR (400 MHz, CDCl₃) δ 8.36 (t, J = 0.8 Hz, 1H), 8.18 (dd, J = 8.0, 1.5 Hz, 1H), 7.70 (dd, J = 8.0, 0.5 Hz, 1H), 3.23 (s, 2H).

### (Result of mass spectrometry)

MS (MALDI-TOF) m/z: [M-H], 270.93; Found, 269.84.

### (2-4) Synthesis of

### 2,2'-(((4,8-bis(5-(2-butyloctyl)thiophen-2-yl)benzo[1,2-b:4,5-b']dithiophene-2,6-diyl)bi s(3,4'-dihexyl-[2,2'-bithiophene]-5',5-diyl))bis(methaneylylidene))bis(5-iodo-1H-inden e-1,3(2H)-dione) (Compound 7: Exemplified Compound 19)

In the same method of the reaction where Compound 2 and Compound 1 are reacted to synthesize Compound 3, synthesis and purification are performed using Compound 2 (636 mg, 0.450 mmol) and Compound 6 (269 mg, 0.990 mmol), to thereby obtain a black solid of Compound 7 (Exemplified Compound 19) (yield = 806 mg, 93%).

A reaction formula of the above-described reaction, and NMR spectrum values of obtained Compound 6 (Exemplified Compound 19) and a result of mass spectrometry thereof are presented below.

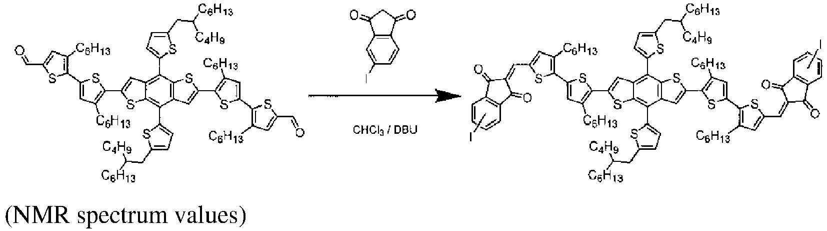

¹H NMR(500MHz,CDCl₃) δ 8.27 (dd, J = 8.5, 1.3 Hz, 2H), 8.08-8.05 (m, 2H), 7.85 (d, J = 4.4 Hz, 2H), 7.78 (d, J = 7.9 Hz, 2H), 7.70 (d, J = 1.6 Hz, 2H), 7.63 (dd, J = 10.4, 7.9 Hz, 2H), 7.39 (d, J = 3.2 Hz, 2H), 7.30 (s, 2H), 6.94 (d, J = 3.5 Hz, 2H), 2.91-2.82 (m, 12H), 1.78-1.70 (m, 10H), 1.44-1.29 (m, 56H), 0.93-0.85 (m, 24H). ¹³C NMR (126 MHz, CDCl₃) δ 189.76, 189.11, 189.04, 188.26, 146.22, 146.06, 145.96, 145.88, 145.84, 143.88, 143.69, 143.07, 142.09, 141.59, 141.27, 141.11, 139.58, 139.26, 137.16, 136.92, 136.68, 136.59, 136.54, 134.75, 134.33, 134.14, 132.27, 132.20, 131.34, 128.10, 125.73, 124.31, 124.16, 123.68, 122.97, 122.21, 102.88, 102.62, 40.21, 34.92, 33.63, 33.20, 32.12, 31.85, 31.82, 30.71, 30.12, 29.92, 29.88, 29.55, 29.36, 29.07, 26.85, 23.26, 22.89, 22.87, 22.81, 22.70, 14.39, 14.32, 14.30.

### (Result of mass spectrometry)

MS (MALDI-TOF) m/z: [M+H]⁺, 1920.51; Found, 1920.97. Anal. calcd (%) for C₁₀₂H ₁₂₀I₂O₄S₈: C 63.80, H 6.30; found: C 63.80, H 6.24.

### Examples

The present disclosure will be described in more detail by way of the following Examples. However, the present disclosure should not be construed as being limited to these Examples.

Moreover, each Exemplified Compound used in Examples as the compound represented by General Formula (1) was synthesized according to the synthesis methods of Exemplified Compounds 17 and 19 by appropriately changing reagents for use.

### (Example 1)

### (Production of electron-transporting layer)

Zinc acetate (available from Sigma-Aldrich Co., LLC) in an amount of 1 g, 0.28 g of ethanolamine (available from Sigma-Aldrich Co., LLC), and 10 mL of methoxyethanol (available from Wako Pure Chemical Industries, Ltd.) were stirred overnight at room temperature to thereby prepare a zinc oxide precursor solution. The zinc oxide precursor solution was applied onto an ITO substrate by spin coating in a manner that a film thickness was to be 20 nm, and the applied solution was dried for 10 minutes at 200 degrees Celsius, to thereby form an electron-transporting layer.

### (Production of photoelectric conversion layer)

In chloroform (1 mL), 18 mg of Exemplified Compound 3 and 12 mg of PC71BM (available from Frontier Carbon Corporation) were dissolved to prepare a photoelectric conversion solution. Onto the above-described electron-transporting layer, the photoelectric conversion solution was applied by spin coating, to thereby form a photoelectric conversion layer. The film thickness thereof was 401 nm.

### (Production of hole-transporting layer and metal electrode)

On the photoelectric conversion layer, molybdenum oxide (available from KOJUNDO CHEMICAL LABORATORY CO., LTD.) in the thickness of 10 nm, and silver in the thickness of 100 nm were sequentially formed by vacuum vapor deposition, to thereby produce a solar battery cell.

### (Evaluation)

Short-circuit current density of the obtained photoelectric conversion element with irradiation of white LED (34 microwatt/cm²) was measured.

The measurement was performed by using a desk lamp CDS-90 alpha available from Cosmotechno Co., Ltd. as the white LED, and a solar battery evaluation system As-510-PV03 available from NF Corporation as the evaluation device. The output of the LED light source was measured by means of a color meter C-7000 available from SEKONIC CORPORATION. The evaluation result was presented in Table 2.

### (Examples 2 to 11)

Solar battery cells of Examples 2 to 11 were each produced and evaluated in the same manner as in Example 1, except that Exemplified Compound 3 used in Example 1 was changed to Exemplified Compound presented in Table 2. The film thickness and evaluation results are presented in Table 2.

### (Comparative Example 1)

A photoelectric conversion element was produced and evaluated in the same manner as in Example 1, except that the production method of the photoelectric conversion layer in Example 1 was changed as follows. The film thickness and evaluation results are presented in Table 2.

In chloroform (1 mL), 18 mg of Comparative Compound 1 below and 12 mg of PC71BM (available from Frontier Carbon Corporation) were dissolved to prepare a photoelectric conversion solution. Onto the above-described electron-transporting layer, the photoelectric conversion solution was applied by spin coating, to thereby form a photoelectric conversion layer.

### (Comparative Example 2)

A photoelectric conversion element was produced and evaluated in the same manner as in Example 1, except that the production method of the photoelectric conversion layer in Example 1 was changed as follows. The film thickness and evaluation results are presented in Table 2.

In chloroform (1 mL), 18 mg of Comparative Compound 2 below and 12 mg of PC71BM (available from Frontier Carbon Corporation) were dissolved to prepare a photoelectric conversion solution. Onto the above-described electron-transporting layer, the photoelectric conversion solution was applied by spin coating, to thereby form a photoelectric conversion layer.

### (Comparative Example 3)

A photoelectric conversion element was produced and evaluated in the same manner as in Example 1, except that the production method of the photoelectric conversion layer in Example 1 was changed as follows. The film thickness and evaluation results are presented in Table 2.

In chloroform (1 mL), 18 mg of Comparative Compound 3 below and 12 mg of PC71BM (available from Frontier Carbon Corporation) were dissolved to prepare a photoelectric conversion solution. Onto the above-described electron-transporting layer, the photoelectric conversion solution was applied by spin coating, to thereby form a photoelectric conversion layer.

### (Comparative Example 4)

A photoelectric conversion element was produced and evaluated in the same manner as in Example 1, except that the production method of the photoelectric conversion layer in Example 1 was changed as follows. The film thickness and evaluation results are presented in Table 2.

In chloroform (1 mL), 18 mg of Comparative Compound 4 below and 12 mg of PC71BM (available from Frontier Carbon Corporation) were dissolved to prepare a photoelectric conversion solution. Onto the above-described electron-transporting layer, the photoelectric conversion solution was applied by spin coating, to thereby form a photoelectric conversion layer.

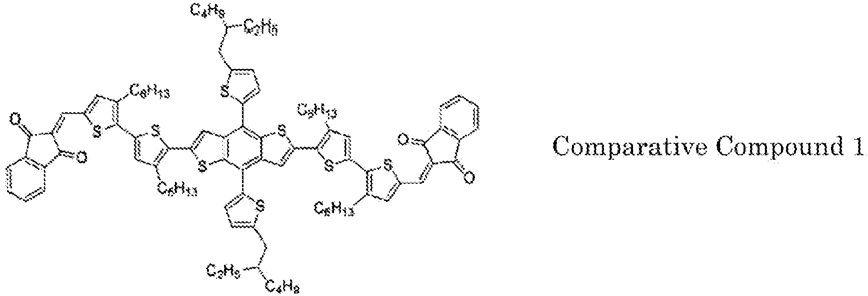

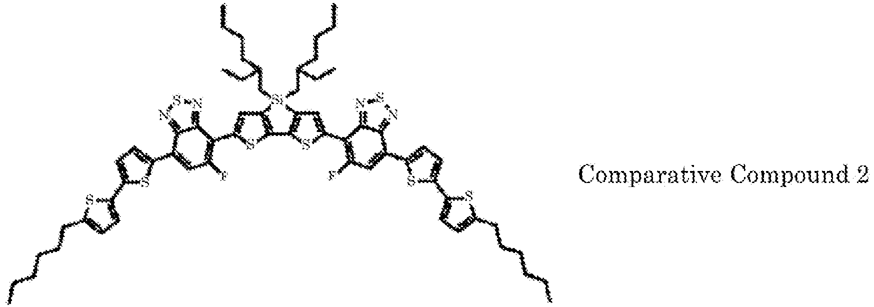

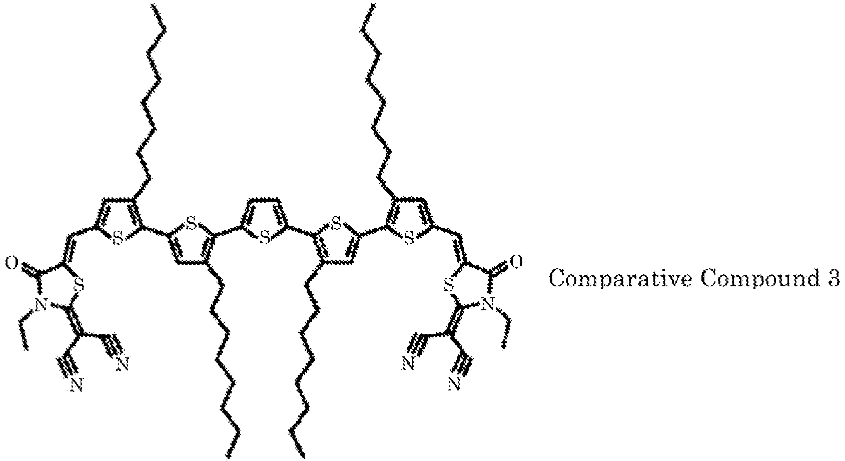

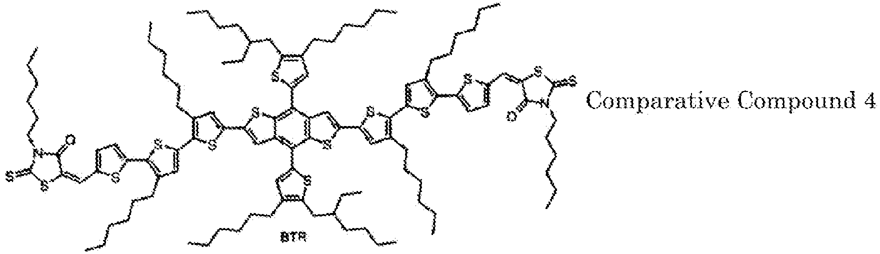

**[Table 2]**

| | Exemplified Compound No. | Film thickness (nm) | Short-circuit current density (µA/cm²) |
|---|---|---|---|
| Ex. 1 | 3 | 401 | 22.7 |
| Ex. 2 | J | 412 | 21.5 |
| Ex. 3 | 7 | 423 | 22.1 |
| Ex. 4 | 11 | 395 | 20.3 |
| Ex. 5 | 13 | 398 | 20.9 |
| Ex. 6 | 10 | 404 | 21.6 |
| Ex. 7 | 19 | 391 | 25.4 |
| Ex. 8 | 23 | 402 | 24.2 |
| Ex. 9 | 27 | 411 | 23.7 |
| Ex. 10 | 31 | 408 | 20.9 |
| Ex. 11 | 43 | 421 | 25.1 |
| Comp. Ex. 1 | Comparative Compound 1 | 398 | 12.9 |
| Comp. Ex. 2 | Comparative Compound 2 | 406 | 11.0 |
| Comp. Ex. 3 | Comparative Compound 3 | 421 | 13.8 |
| Comp. Ex. 4 | Comparative Compound 4 | 410 | 11.7 |

The photoelectric conversion elements produced using the organic materials obtained in the above-described manner in the present disclosure were extremely excellent photoelectric conversion materials having high short-circuit current density with very weak light of 34 microwatt/cm², compared to the comparative photoelectric conversion elements.

### Reference Signs List

1: substrate
2: first electrode
3: electron-transporting layer
4: photoelectric conversion layer
5: hole-transporting layer
6: second electrode
10: photoelectric conversion element
11: device circuit
12: power supply IC
13: power storage device
20: commercial power supply
21: device circuit
22: AC-DC converter
23: battery cell

## Claims

1. A photoelectric conversion element comprising:
a substrate (1);
a first electrode (2);
an electron-transporting layer (3);
a photoelectric conversion layer (4);
a hole-transporting layer (5); and
a second electrode, where the first electrode, the electron-transporting layer, the photoelectric conversion layer, the hole-transporting layer, and the second electrode are disposed on or above the substrate,
**characterised in that** the photoelectric conversion layer includes an organic material
represented by General Formula (1) below, and a N-type semiconductor material, 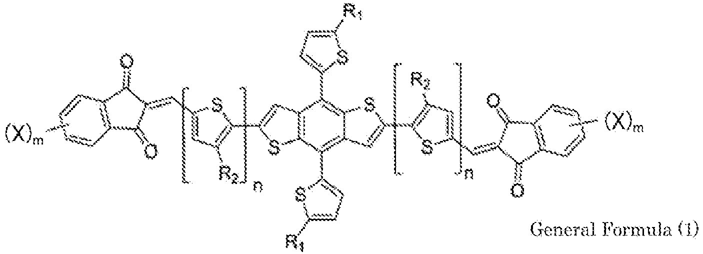 where, in General Formula (1), R₁ and R₂ are each independently an alkyl group having 6 or more but 22 or less carbon atoms, n is each independently an integer of from 1 through 3, X is each independently a halogen atom, and m is each independently 1 or 2.

2. The photoelectric conversion element according to claim 1,
wherein X of General Formula (1) is a bromine atom or an iodine atom.

3. The photoelectric conversion element according to claim 1,
wherein the compound represented by General Formula (1) is a compound represented by General Formula (2) below, 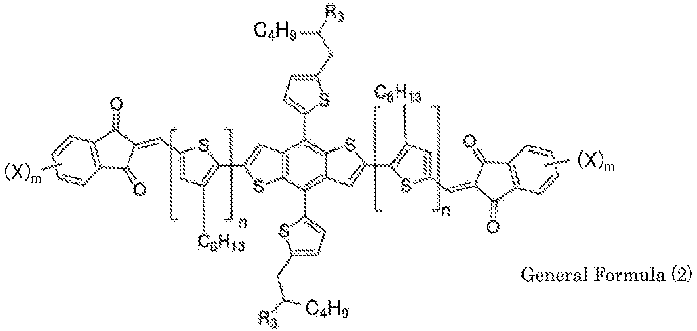 where, in General Formula (2), R₃ is each independently an alkyl group having 2 or more but 6 or less carbon atoms, n is each independently an integer of from 1 through 3, X is each independently a bromine atom or an iodine atom, and m is each independently 1 or 2.

4. The photoelectric conversion element according to any one of claims 1 to 3,
wherein the N-type semiconductor material is a fullerene derivative.

5. The photoelectric conversion element according to any one of claims 1 to 4,
wherein an average thickness of the photoelectric conversion layer is from 50 nm through 600 nm.

6. A device comprising:
the photoelectric conversion element according to any one of claims 1 to 5,
wherein the device is driven by electricity generated by the photoelectric conversion element.

7. A power supply module comprising:
the photoelectric conversion element according to any one of claims 1 to 5.

## Patentansprüche

1. Photoelektrisches Umwandlungselement, das Folgendes umfasst:
ein Substrat (1);
eine erste Elektrode (2);
eine Elektronentransportschicht (3);
eine photoelektrische Umwandlungsschicht (4);
eine Lochtransportschicht (5); und
eine zweite Elektrode, worin die erste Elektrode, die Elektronentransportschicht, die photoelektrische Umwandlungsschicht, die Lochtransportschicht, und die zweite Elektrode auf oder über dem Substrat angeordnet sind,
**dadurch gekennzeichnet, dass** die photoelektrische Umwandlungsschicht ein organisches Material das durch die nachstehende Allgemeine Formel (1) dargestellt wird, und ein N-Typ-Halbleitermaterial einschließt, 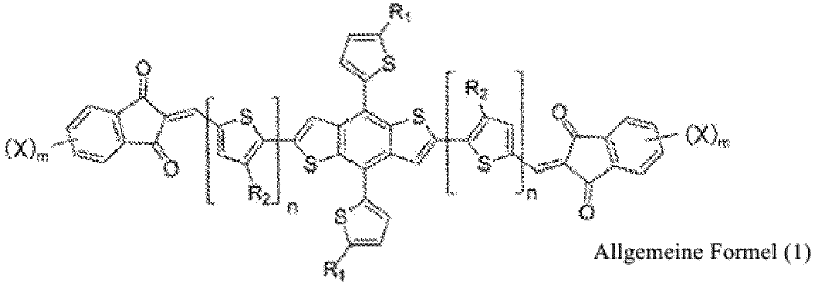
worin in der Allgemeinen Formel (1) R₁ und R₂ jeweils unabhängig eine Alkylgruppe mit 6 oder mehr, aber 22 oder weniger Kohlenstoffatomen sind, n jeweils unabhängig eine ganze Zahl von 1 bis 3 ist, X jeweils unabhängig ein Halogenatom ist und m jeweils unabhängig 1 oder 2 ist.

2. Photoelektrisches Umwandlungselement nach Anspruch 1,
wobei X der Allgemeinen Formel (1) ein Bromatom oder ein Jodatom ist.

3. Photoelektrisches Umwandlungselement nach Anspruch 1,
wobei die durch die Allgemeine Formel (1) dargestellte Verbindung eine durch die nachstehende Allgemeine Formel (2) dargestellte Verbindung ist, 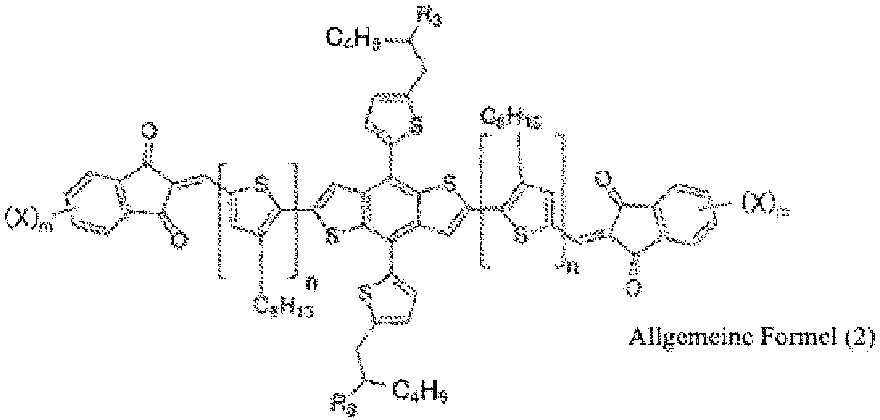 worin in der Allgemeinen Formel (2) R₃ jeweils unabhängig eine Alkylgruppe mit 2 oder mehr, aber 6 oder weniger Kohlenstoffatomen ist, n jeweils unabhängig eine ganze Zahl von 1 bis 3 ist, X jeweils unabhängig ein Bromatom oder ein Jodatom ist und m jeweils unabhängig 1 oder 2 ist.

4. Photoelektrisches Umwandlungselement nach einem der Ansprüche 1 bis 3, wobei das N-Typ-Halbleitermaterial ein Fulleren-Derivat ist.

5. Photoelektrisches Umwandlungselement nach einem der Ansprüche 1 bis 4, wobei eine durchschnittliche Dicke der photoelektrischen Umwandlungsschicht von 50 nm bis 600 nm beträgt.

6. Vorrichtung, Folgendes umfassend:
das photoelektrische Umwandlungselement nach einem der Ansprüche 1 bis 5,
wobei die Vorrichtung durch Elektrizität angetrieben wird, die durch das photoelektrische Umwandlungselement erzeugt wird.

7. Stromversorgungsmodul umfassend:
das photoelektrische Umwandlungselement nach einem der Ansprüche 1 bis 5.

## Revendications

1. Elément de conversion photoélectrique, comprenant :
un substrat (1) ;
une première électrode (2) ;
une couche de transport d'électrons (3) ;
une couche de conversion photoélectrique (4) ;
une couche de transport de trous (5) ; et
une deuxième électrode, où la première électrode, la couche de transport d'électrons, la couche de conversion photoélectrique, la couche de transport de trous, et la deuxième électrode sont disposées sur ou au-dessus du substrat,
**caractérisé en ce que** la couche de conversion photoélectrique inclut un matériau organique représenté par la formule générale (1) ci-dessous, et un matériau semi-conducteur de type N, 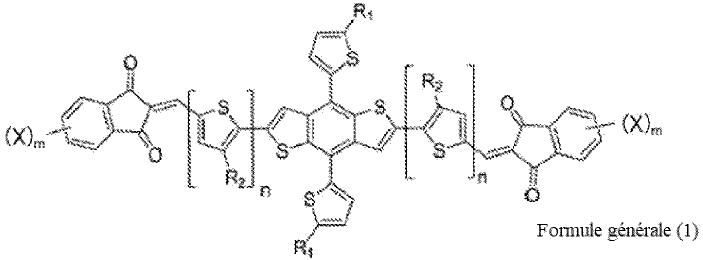 où, dans la formule générale (1), R₁ et R₂ sont chacun indépendamment un groupe alkyle ayant 6 ou plus, mais 22 ou moins atomes de carbone, n est chacun indépendamment un nombre entier de 1 à 3, X est chacun indépendamment un atome d'halogène , et m vaut chacun indépendamment 1 ou 2.

2. Elément de conversion photoélectrique selon la revendication 1,
dans lequel X de la formule générale (1) est un atome de brome ou un atome d'iode.

3. Elément de conversion photoélectrique selon la revendication 1,
dans lequel le composé représenté par la formule générale (1) est un composé représenté par la formule générale (2) ci-dessous, 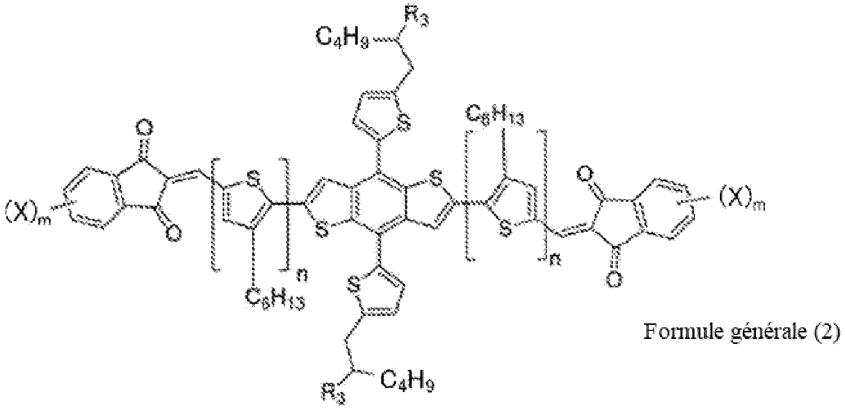 où, dans la formule générale (2), R₃ est chacun indépendamment un groupe alkyle ayant 2 ou plus, mais 6 ou moins atomes de carbone, n est chacun indépendamment un nombre entier de 1 à 3, X est chacun indépendamment un atome de brome ou un atome d'iode , et m vaut chacun indépendamment 1 ou 2.

4. Elément de conversion photoélectrique selon l'une quelconque des revendications 1 à 3,
dans lequel le matériau semi-conducteur de type N est un dérivé de fullerène.

5. Elément de conversion photoélectrique selon l'une quelconque des revendications 1 à 4, dans lequel une épaisseur moyenne de la couche de conversion photoélectrique est de 50 nm à 600 nm.

6. Dispositif comprenant :
l'élément de conversion photoélectrique selon l'une quelconque des revendications 1 à 5,
le dispositif étant entraîné par l'électricité générée par l'élément de conversion photoélectrique.

7. Module d'alimentation comprenant :
l'élément de conversion photoélectrique selon l'une quelconque des revendications 1 à 5.
